# EUROPEAN PATENT SPECIFICATION

(11) **EP 2 178 219 B1**
(45) Date of publication and mention of the grant of the patent: **08.06.2011**
(21) Application number: 08290986.2
(22) Date of filing: 20.10.2008
(51) Int. Cl.: H04B 1/04, H03F 1/56, H03H 7/38

(54) **A method for broadband matching and a network element thereof**
Verfahren zur Breitbandanpassung und ein entsprechendes Netzelement
Procédé de correspondance de bande passante et élément de réseau correspondant

(43) Date of publication of application: 21.04.2010
(73) Proprietor: Alcatel Lucent, 75008 Paris (FR)
(72) Inventor: Pascht, Andreas Dr.-Ing., 73614 Schorndorf (DE); Bitzer, Thomas Dipl.-Ing., 73614 Schorndorf (DE); Matz, Ralf Dipl.-Ing., 71566 Althütt (DE)
(74) Representative: Schmidt, Werner Karl

(56) References cited:
- EP-A- 1 936 814
- US-A- 5 774 017
- US-A1- 2003 220 081
- US-B1- 6 317 608

## Description

### Technical field

The invention relates to a network element for broadband matching for multi-band mobile communication systems, to a method for broadband matching and power amplifiers, to a multi-band mobile communication system.

### Background and related art

A number of digital mobile telephone standards are currently deployed worldwide. These standards include the European GSM and UMTS, and in the USA the CDMA standard. Due to the increasing demand for mobile telephone services, many of these standards are deployed together, and further deployments of new standards, currently being drafted or in deployment trials, are foreseeable. These new standards include the Long Term Evolution (LTE) and the IEEE 802.16.

The European Telecommunications Standards Institute (ETSI) has developed the so called third generation mobile environment known as the Universal Mobile Telecommunication System (UMTS) which is in operation since 2002. UMTS operates in the 2 GHz frequency band and offers data transmission rates of up to 2 Mbits/sec, specially with the new enhancements of High Speed Downlink Access (HSDPA), compared to a rate of 9.6 Kbits/sec offered by the GSM standard.

In the transition from second generation standards to third or forth generation standards, both second and third generation standards currently coexist and will continue to do so. Therefore, multiband communication systems, that include two or more frequency bands belonging to the two or more communication standards will continue coexisting in parallel and working together to provide coverage and services to the mobile stations.

Document US 5774017 discloses a circuit comprising a dualband power amplifier, matching circuits and switches for connecting the input and output of the power amplifier to the corresponding impedance matching circuit according to the frequency band in use.

### Summary of the Invention

The problem is solved by the features of claim 1.

The invention relates to a network element for broadband matching for a multiband mobile communication systems comprising: a power amplifier with a first input and output port; a first set of narrowband matching stages comprising each narrowband matching stage comprising a second input and output port; a first set of quarter-wavelength transmission lines connecting the second output ports of each narrowband matching stage of the first set with the first input port of the power amplifier; a second set of narrowband matching stages comprising each a third input and output port; and a second set of quarter-wavelength transmission lines connecting the third input port of each narrowband matching stage of the second set with the first output port of the power amplifier.

The term 'quarter wavelength' as expressed herein refers to the wavelength of the corresponding centre frequency of the filter. The quarter wavelength is different for each filter and therefore the transmission lines have different lengths.

One of the advantages of the invention is that allows simultaneous operation in different frequency bands. Further, the decoupling between the different matching stages is achieved, as the matching stages represent a short circuit in the stop-bands, which covers the frequency range in which the other matching stages are working. This short circuit is transformed by the quarter-wavelength transmission lines into an open circuit at the connection points of the set of quarter-wavelength transmission lines. Therefore, the matching stages do not influence each other in the target frequency bands, and in general any number of frequency bands and of narrow-band matching stages may be used.

In an embodiment, the narrowband matching stages are frequency selective filters; wherein each filter has a stop band, a pass band around a carrier frequency, wherein each filter is designed for maximum reflection at the output port in the stop bands; wherein each narrowband matching stage is designed for a different frequency band.

In a further embodiment, the first and second set of quarter-wavelength transmission lines transform a short circuit into an open circuit connection, wherein the narrowband matching stages represent a short circuit at the second and third input and output ports in the stop band.

In a further embodiment, the first set of narrowband matching stages transform impedances from a first impedance at the second input ports to a set of second impedances at the second output ports; wherein the second set of narrowband matching stages transform impedance from a third impedance at the third input port to a forth impedance at the third output port.

In a further embodiment, the narrowband matching stages maximize the power transmission from the input ports to the output ports of the first and second sets.

In a further embodiment, a third set of quarter-wavelength transmission lines connects a first connection point with the second inputs of the first set of narrowband matching stages.

In a further embodiment, a fourth set of quarter-wavelength transmission lines connects the third output ports of the second set of narrowband matching stages with a second connection point.

In a further embodiment, the second connection point is coupled to an antenna.

In a further embodiment, the first and second set of narrowband matching stages are adapted for no reflection in the pass band at the output ports, wherein the output ports of the filters are designed as short circuit connections in the stop bands, wherein the quarter-wavelength transmission lines are adapted for transforming the short circuit connection into an open circuit connection at the first and the second connection point.

In another aspect, the invention relates to a method for broadband matching on power amplifiers in a network element of a multi-band mobile communication system, the method comprising:
- sending a multi-band frequency signal from a first connection point to first input ports of a first set of narrowband matching stages via a first set of quarter-wavelength transmission lines;
- transforming the impedances in multiple frequency bands by the first set of narrowband matching stages from a first impedance at the first input ports to a set of second impedances at first output ports of the first set of narrowband matching stages;
- transmitting the multi-band signal from the output ports of the first set of narrowband matching stages to a second input port of a power amplifier via a second set of quarter-wavelength transmission lines;
- amplifying power of the multi-band frequency signal with the power amplifier;
- transmitting the multi-band signal from a second output port of the power amplifier to third input ports of a second set of narrowband matching stages via a third set of quarter-wavelength transmission lines.

In an embodiment, the method further comprising:
- transforming the impedances in multiple frequency bands by the second set of narrowband matching stages from a third set of impedances at the third input ports to a fourth impedance at third output ports of the second set of narrowband matching stages;
- transmitting the multi-band signal from the third output ports of the second set of narrowband matching stages to a second connection point via a fourth set of quarter-wavelength transmission lines. In a further embodiment, the second connection point is coupled to an antenna.

In a further embodiment, the narrowband matching stages are frequency selective filters; wherein each filter has a stop band, a pass band around a carrier frequency, an input port, an output port, wherein each filter is designed for maximum reflection at the output port in the stop bands; wherein each narrowband matching stage is designed for a different frequency band.

In another aspect, the invention relates to a multi-band mobile communication system applying broadband matching of power amplifiers, the mobile communication system being operable to perform in accordance with any one of the preceding embodiments.

In another aspect, the invention relates to a computer program product stored on a storage medium, comprising executable program means for causing a network element to perform a method according to any of the preceding embodiments when the program is run on the network element.

### Brief description of the drawings

In the following preferred embodiments of the invention will be described in greater detail by way of example only making reference to the drawings in which:
- Figure 1: shows an example of the prior art,
- Figure 2: shows an embodiment of the network element,
- Figure 3: shows simulations results for the multi-band mobile communication system,
- Figure 4: shows a block diagram of the impedance characteristics within the network element,
- Figure 5: shows a method according to the embodiments of the invention.

### Detailed description

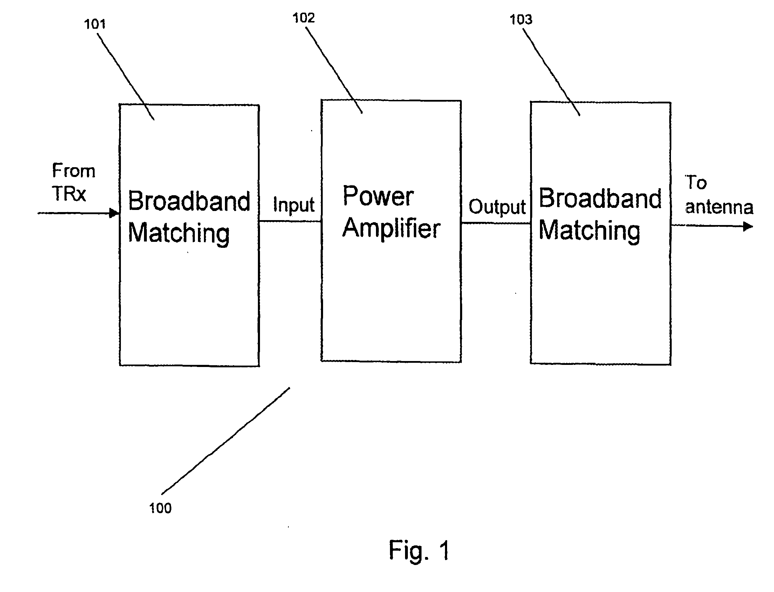

Fig. 1 shows a network element for broadband matching 100 according to the prior art. The network element 100 comprises a first broadband matching stage 101, a power amplifier 102 and a second broadband matching stage 103.

In the network element of fig. 1, for any frequency band, the same broadband matching stage is used. Since broadband matching cannot be achieved in such a precise way as narrow-band matching, the power amplifier is not as efficient as in the case of using dedicated narrow-band matching stages.

An alternative implementation of the prior art is to substitute the broadband matching with dedicated narrow-band matching stages, in order to increase the efficiency in the respective bands in which the signal is amplified. This prior art implementation requires four switches, one for each input and output port of the matching stages 101 and 103, and due to the switching, there is no simultaneous multi-band operation possible. Furthermore, the switching devices may introduce non-linearities.

Usually, the switching elements are non-linear components, as for example the pin diodes. These devices introduce non-linearity in the signal path and may degrade the signal quality. Also, due to the switching of the matching stages for different frequency bands, it is not possible to operate the power amplifier in different frequency bands at the same time.

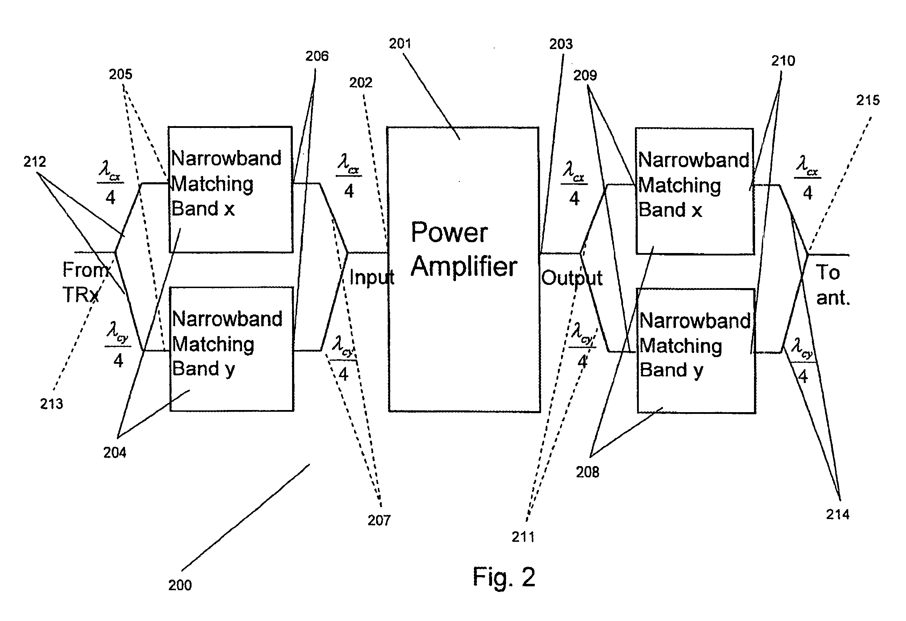

Fig. 2 shows a network element 200 according to an embodiment of the invention. The network element 200 comprises a power amplifier 201 with the first input port 202 and an output port 203, a first set of narrow-band matching stages 204, each narrow-band matching stage including a second input port 205 and a second output port 206. The network element 200 further comprises a first set of quarter-wavelength transmission lines 207 connecting the second output ports 205 of each narrow-band matching stages with the first input port 202 of the power amplifier 201; a second set of narrow-band matching stages 208 comprising third input ports 209 and third output ports 210. The network element 200 further comprises a second set of quarter-wavelength transmission lines 211 connecting the third input ports 209 of each narrow-band matching stage of the second set with the first output port 203 of the power amplifier 201.

The network element 200 further comprises a third set of quarter-wavelength transmission lines 212 connecting a first connection point 213 with the second input ports 205 of the first set of narrow-band matching stages 204. The network element may also include a fourth set of quarter-wavelength transmission lines 214 connecting the third output ports 210 of the second set of narrow-band matching stages 208 with a second connection point 215. The second connection point may be coupled to an antenna, not shows in the figure.

The network element of the embodiment represented in fig. 2 uses several dedicated narrow-band matching stages in order to overcome the poor efficiency of using a broadband matching stage, as represented in fig. 1. In order to overcome the disadvantages of using switches, the narrow-band matching stages are not connected to the power amplifier via switches, but by quarter-wavelength transmission lines. This allows simultaneous operation in different frequency bands. Also, the decoupling between the different matching stages is achieved, as the matching stages represent a short circuit in the stop-bands, which covers the frequency range in which the other matching stages are working. This short circuit is transformed by the quarter-wavelength transmission lines into an open circuit at the connection points of the set of quarter-wavelength transmission lines. Therefore, the matching stages do not influence each other in the target frequency bands, and in general, any number of frequency bands and of narrow-band matching stages may be used.

The narrow-band matching stages are frequency selective filters and the characteristics of these filters include having a stop-band, a pass-band around a carrier frequency, and each filter is adapted for a maximum reflection at the output port in the stop-bands. Further, each narrow-band matching stage is designed for a different frequency band.

The first and second set of quarter-wavelength transmission lines transform a short circuit into an open circuit, and the narrow-band matching stages represent a short circuit at the second and third input and second and third output ports in the stop-band area.

Further, the first set of narrow-band matching stages transform the output impedance of a preceding signal path which generates a multi-band signal to a set of second impedances at the second output ports. In general, in the different frequency bands, different impedances may be required due to the frequency dependant input impedance of the following power amplifier. The power amplifier features a set of third impedances at the input port and a set of fourth impedances at the output port. In general, the input and output impedances are different at different frequencies. Also, the second set of narrow-band matching stages transforms the impedances of the power amplifier output to a fourth impedance at the third output ports.

The first and second sets of narrow-band matching stages maximize the power transmission from the input ports to the output ports.

The first and the second set of narrow-band matching stages are adapted for no reflection in the pass-band at the output ports. The output ports of the filters are designed as a short connection in the stop bands. Also, the quarter-wavelength transmission lines are designed for transforming the short circuit connection into an open circuit connection at the first and the second connection point.

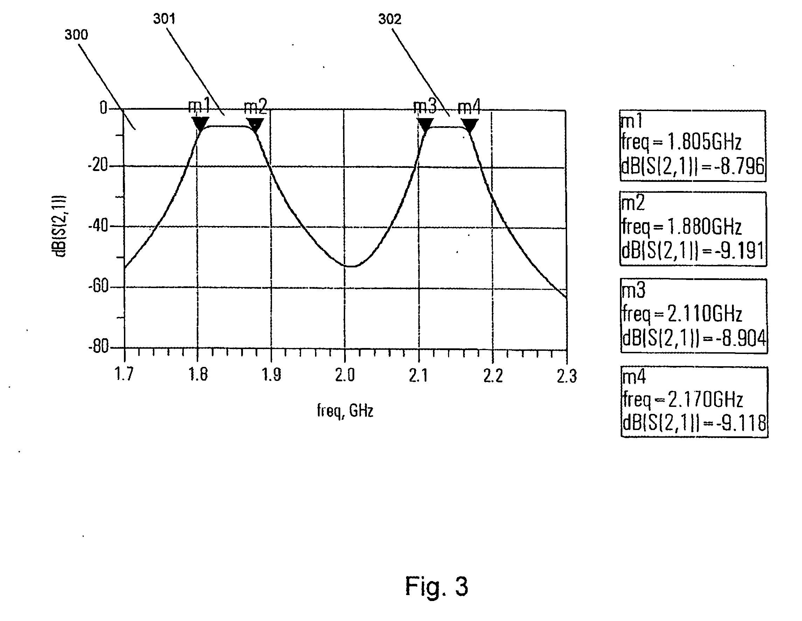

Fig. 3 shows a graphic 300 with the simulation results obtained for the multi-band communication system in the example assuming the GSM 1800 frequency band 301 around 1800 MHz and the UMTS core band 302 around 2140 MHz. The graphic 300 clearly shows the decoupling obtained between the two frequency bands in the 1800 MHz band and the 2140 MHz band. The simulations are a result of using the quarter-wavelength transmission lines that decouple all the narrow-band matching stages between each other and the use of the narrow-band matching stages that are optimized for the specific frequency band.

The embodiments present less efficiency degradation compared to prior art alternatives, simultaneous operations in different frequency bands are possible as no switches are used, and the non-linearities are avoided. The embodiments combine the frequency selective matching stages with a broadband power amplifier. Compared to a broadband matching, the degradation of the efficiency can be significantly reduced. With respect to a modular concept, the filter stage can be customized very easily. Depending on the demands of the mobile communication system, the filter may be changed and different frequency bands can be addressed.

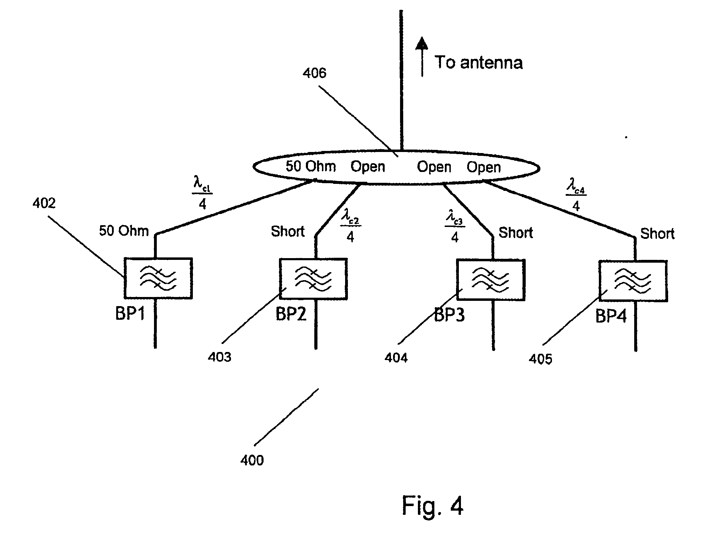

Fig. 4 shows an example of the connection principle of the quarter wavelength transmission lines between the filters and the connection points. The section of the network element 400 comprises four transmission filters 402-405 connected to a common connection point 406 that is further connected to an antenna not shown in the figure.

If a signal is transmitted at the carrier frequency 1 through the first filter 402 the pass band of the first filter 402 is centered around the same carrier frequency. At this frequency, the other filters 403-405 are operated in the stop bands and the output ports of these three filters 403-405 act as a short circuit connection. The quarter wavelength transmission lines transform this short circuit connection to an open circuit connection at the connection point 406. Therefore, the transmitted signal from the first filter only sees open connections and the only path that it may take is the path leading to the antenna. As a result the different paths are decoupled from each other and there is no interference between them.

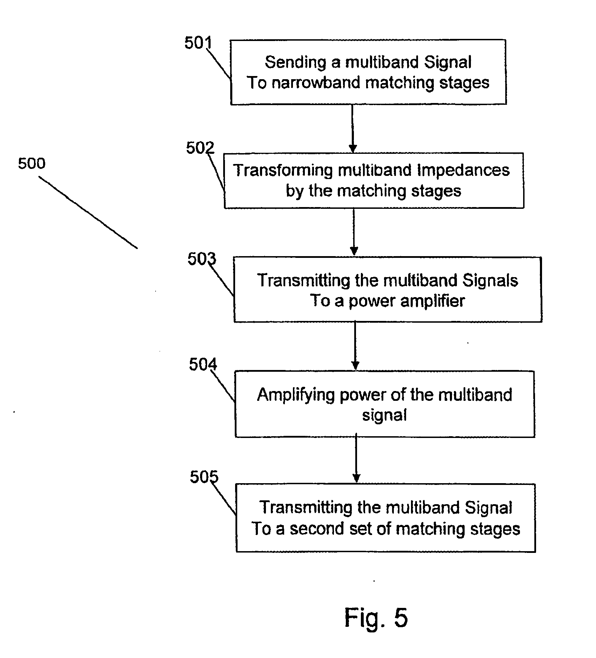

Fig.5 shows a method 500 for broadband matching on power amplifiers in a network element of a multi-band mobile communication system. The method comprises: In a first step 501, sending a multi-band frequency signal from a first connection point to first input ports of a first set of narrowband matching stages via a first set of quarter-wavelength transmission lines. In a second step 502, transforming impedances in multiples frequency bands by said first set of narrowband matching stages from a first impedance at said first input ports to a set of second impedances at first output ports of said first set of narrowband matching stages.

In a third step 503, transferring said multi-band frequency signal from said output ports of said first set of narrowband matching stages to a second input port of a power amplifier via a second set of quarter-wavelength transmission lines. In a forth step 504, amplifying power of said multi-band frequency signal with said power amplifier. In a fifth step 505, transferring said multi-band signal from a second output port of said power amplifier to third input ports of a second set of narrowband matching stages via a third set of quarter-wavelength transmission lines.

### List of reference numerals

| | |
|---|---|
| 100 | Prior art network element |
| 101 | Broadband matching stage |
| 102 | Power amplifier |
| 103 | Second broadband matching |
| 200 | Network element |
| 201 | Power amplifier |
| 202 | First input port |
| 203 | Second output port |
| 204 | First set of quarter-wavelength transmission lines |
| 205 | Second input ports |
| 206 | Second output ports |
| 207 | First set of transmission lines |
| 208 | Second set of quarter-wavelength transmission lines |
| 209 | Third input ports |
| 210 | Third output ports |
| 211 | Third set of transmission lines |
| 212 | First connection point |
| 213 | Fourth set of transmission lines |
| 214 | Second connection point |
| 300 | Graphic of the simulation results |
| 301 | First frequency band |
| 302 | Second frequency band |
| 400 | Network element section |
| 402 | First filter |
| 403 | Second filter |
| 404 | Third filter |
| 405 | Forth filter |
| 500 | Method steps |
| 501 | First filter |
| 502 | Second filter |
| 503 | Third filter |
| 504 | Forth filter |
| 505 | Fifth filter |

## Claims

1. A network element (200) for broadband matching for a multiband mobile communication systems comprising:
- a power amplifier (201) with a first input port (202) and a first output port (203);
- a first set of narrowband matching stages (204), each narrowband matching stage of said first set comprising a second input port (205) and a second output port (206);
- a first set of quarter-wavelength transmission lines (207) connecting said second output ports (206) of each narrowband matching stage of said first set (204) with said first input port (202) of said power amplifier (201);
- a second set of narrowband matching stages (208) comprising each a third input port (209) and a third output port (210);
- a second set of quarter-wavelength transmission lines (211) connecting said third input port (209) of each narrowband matching stage of said second set (208) with said first output port (203) of said power amplifier (201).

2. The network element of claim 1, wherein said first and said second set of narrowband matching stages (204, 208) are frequency selective filters; wherein each filter has a stop band, a pass band around a carrier frequency, wherein each filter is designed for maximum reflection at said output ports in said stop bands; wherein each narrowband matching stage is designed for a different frequency band.

3. The network element of claim 1 or claim 2, wherein said first (207) and said second set of quarter-wavelength transmission lines (211) transform a short circuit into an open circuit connection, wherein said narrowband matching stages (204, 208) represent a short circuit at said second and third input and output ports in said stop band.

4. The network element of claim 1, wherein said first set of narrowband matching stages transform impedances from a first impedance at said second input ports to a set of second impedances at said second output ports; wherein said second set of narrowband matching stages transform impedance from a third impedance at said third input port to a forth impedance at said third output port.

5. The network element of claim 1, wherein said narrowband matching stages maximize the power transmission from said input ports to said output ports of said first and second sets.

6. The network element of claim 1, wherein a third set of quarter-wavelength transmission lines (212) connects a first connection point (213) with said second inputs (205) of said first set of narrowband matching stages (204).

7. The network element of claim 1, wherein a fourth set of quarter-wavelength transmission lines (214) connects said third output ports (210) of said second set of narrowband matching stages (208) with a second connection point (215).

8. The network element of claim 7, wherein said second connection point (215) is coupled to an antenna.

9. The network element of any of the preceding claims, wherein said first (204) and second set of narrowband matching stages (208) are adapted for no reflection in said pass band at said output ports, wherein said output ports of said filters are designed as short circuit confections in said stop bands, wherein said quarter-wavelength transmission lines are adapted for transforming said short circuit connection into an open circuit connection at said first and said second connection point.

10. A method (500) for broadband matching on power amplifiers in a network element of a multi-band mobile communication system, the method comprising:
- sending (501) a multi-band frequency signal from a first connection point to firs input ports of a first set of narrowband matching stages via a first set of quarter-wavelength transmission lines;
- transforming (502) impedances in multiple frequency bands by said first set of narrowband matching stages from a first impedance at said first input ports to a set of second impedances at first output ports of said first set of narrowband matching stages;
- transmitting. (503) said multi-band signal from said output ports of said first set of narrowband matching stages to a second input port of a power amplifier via a second set of quarter-wavelength transmission lines;
- amplifying (504) power of said multi-band frequency signal with said power amplifier;
- transmitting (505) said multi-band signal from a second output port of said power amplifier to third input ports of a second set of narrowband matching stages via a third set of quarter-wavelength transmission lines.

11. The method of claim 10 further comprising:
- transforming said impedances in multiple frequency bands by said second set of narrowband matching stages from a third set of impedances at said third input ports to a fourth impedance at third output ports of said second set of narrowband matching stages;
- transmitting said multi-band signal from said third output ports of said second set of narrowband matching stages to a second connection point via a fourth set of quarter-wavelength transmission lines.

12. The method of claim 11, wherein said second connection point is coupled to an antenna.

13. The method of claim 10 or 11, wherein said narrowband matching stages are frequency selective filters; wherein each filter has a stop band, a pass band around a carrier frequency, an input port, an output port, wherein each filter is designed for maximum reflection at said output port in said stop bands; wherein each narrowband matching stage is designed for a different frequency band.

14. A multi-band mobile communication system applying broadband matching of power amplifiers, the mobile communication system being operable to perform in accordance with any one of the preceding claims 10 to 13.

15. A computer program product stored on a storage medium, comprising executable program means for causing a network element to perform a method according to any of the preceding claims 10 to 13 when the program is run on the network element.

## Patentansprüche

1. Netzelement (200) zur Breitbandanpassung für ein mobiles Mehrbandkommunikationssystem, umfassend:
- einen Leistungsverstärker (201) mit einem ersten Eingangsport (202) und einem ersten Ausgangsport (203);
- einen ersten Satz von Schmalbandanpassungsstufen (204), wobei jede Schmalbandanpassungsstufe des besagten ersten Satzes einen zweiten Eingangsport (205) und einen zweiten Ausgangsport (206) umfasst;
- einen ersten Satz von Viertelwellenlängen-Übertragungsleitungen (207), welche die besagten zweiten Ausgangsports (206) einer jeden Schmalbandanpassungsstufe des besagten ersten Satzes (204) mit dem besagten ersten Eingangsport (202) des besagten Leistungsverstärkers (201) verbinden;
- einen zweiten Satz von Schmalbandanpassungsstufen (208), welche jeweils einen dritten Eingangsport (209) und einen dritten Ausgangsport (210) umfassen (210);
- einen zweiten Satz von Viertelwellenlängen-Übertragungsleitungen (211), welche den besagten dritten Eingangsport (209) einer jeden Schmalbandanpassungsstufe des besagten zweiten Satzes (208) mit dem besagten ersten Ausgangsport (203) des besagten Leistungsverstärkers (201) verbinden.

2. Das Netzelement nach Anspruch 1, wobei der besagte erste und der besagte zweite Satz von Schmalbandanpassungsstufen (204, 208) frequenzselektive Filter sind; wobei jeder Filter ein Sperrband, ein Durchlassband rund um eine Trägerfrequenz, aufweist, wobei jeder Filter für eine maximale Reflexion an den besagten Ausgangsports in den besagten Sperrbändern vorgesehen ist; wobei jede Schmalbandanpassungsstufe für ein verschiedenes Frequenzband vorgesehen ist.

3. Das Netzelement nach Anspruch 1 oder 2, wobei der besagte erste (207) und der besagte zweite Satz von Viertelwellenlängen-Übertragungsleitungen (211) einen Kurzschluss in eine offene Schaltkreisverbindung umwandeln, wobei die besagten Schmalbandanpassungsstufen (204, 208) einen Kurzschluss an den besagten zweiten und dritten Eingangs- und Ausgangsports in dem besagten Sperrband darstellen.

4. Das Netzelement nach Anspruch 1, wobei der besagte erste Satz von Schmalbandanpassungsstufen Impedanzen von einer ersten Impedanz an den besagten zweiten Eingangsports in einen Satz von zweiten Impedanzen an den besagten zweiten Ausgangsports umwandelt; wobei der besagte zweite Satz von Schmalbandanpassungsstufen eine Impedanz von einer dritten Impedanz an dem besagten dritten Eingangsport in eine vierte Impedanz an dem besagten dritten Ausgangsport umwandelt.

5. Das Netzelement nach Anspruch 1, wobei die besagten Schmalbandanpassungsstufen die Leistungsübertragung von den besagten Eingangsports an die besagten Ausgangsports des besagten ersten und des besagten zweiten Satzes maximieren.

6. Das Netzwerkelement nach Anspruch 1, wobei ein dritter Satz von Viertelwellenlängen-Übertragungsleitungen (212) einen ersten Verbindungspunkt (213) mit den besagten zweiten Eingängen (205) des besagten ersten Satzes von Schmalbandanpassungsstufen (204) verbindet.

7. Das Netzwerkelement nach Anspruch 1, wobei ein vierter Satz von Viertelwellenlängen-Übertragungsleitungen (214) die besagten dritten Ausgangsports (210) des besagten zweiten Satzes von Schmalbandanpassungsstufen (208) mit einem zweiten Verbindungspunkt (215) verbindet.

8. Das Netzelement nach Anspruch 7, wobei der besagte zweite Verbindungspunkt (215) an eine Antenne gekoppelt ist.

9. Das Netzelement nach einem beliebigen der vorstehenden Ansprüche, wobei der besagte erste (204) und der besagte zweite Satz von Schmalbandanpassungsstufen (208) für keine Reflexion in dem besagten Durchlassband an den besagten Ausgangsport geeignet sind, wobei die besagten Ausgangsports der besagten Filter als Kurzschlussverbindungen in den besagten Sperrbändern vorgesehen sind, wobei die besagten Viertelwellenlängen-Übertragungsleitungen für das Umwandeln der besagten Kurzschlussverbindung in eine offene Schaltkreisverbindung an dem besagten ersten und dem besagten zweiten Verbindungspunkt ausgelegt sind.

10. Verfahren (500) zur Breitbandanpassung auf Leistungsverstärkern in einem Netzelement eines mobilen Mehrbandkommunikationssystems, wobei das Verfahren umfasst:
- Senden (501) eines Mehrbandfrequenzsignals von einem ersten Verbindungspunkt an erste Eingangsports eines ersten Satzes von Schmalbandanpassungsstufen über einen ersten Satz von Viertelwellenlängen-Übertragungsleitungen;
- Umwandeln (502) von Impedanzen in mehrfachen Frequenzbändern durch den besagten ersten Satz von Schmalbandanpassungsstufen von einer ersten Impedanz an den besagten ersten Eingangsports in einen Satz von zweiten Impedanzen an den ersten Ausgangsports des besagten ersten Satzes von Schmalbandanpassungsstufen;
- Übertragen (503) des besagten Mehrbandsignals von den besagten Ausgangsports des besagten ersten Satzes von Schmalbandanpassungsstufen an einen zweiten Eingangsport eines Leistungsverstärkers über einen zweiten Satz von Viertelwellenlängen-Übertragungsleitungen;
- Verstärken (504) der Leistung des besagten Mehrbandfrequenzsignals mit dem besagten Leistungsverstärker;
- Übertragen (505) des besagten Mehrbandsignals von einem zweiten Ausgangsport des besagten Leistungsverstärkers an dritte Eingangsports eines zweiten Satzes von Schmalbandanpassungsstufen über einen dritten Satz von Viertelwellenlängen-Übertragungsleitungen.

11. Das Verfahren nach Anspruch 10, weiterhin umfassend:
- Umwandeln der besagten Impedanzen in mehrfachen Frequenzbändern durch den besagten zweiten Satz von Schmalbandanpassungsstufen von einem dritten Satz von Impedanzen an den besagten dritten Eingangsports in eine vierte Impedanz an dritten Ausgangsports des besagten zweiten Satzes von Schmalbandanpassungsstufen;
- Übertragen des besagten Mehrbandsignals von den besagten dritten Ausgangsports des besagten zweiten Satzes von Schmalbandanpassungsstufen an einen zweiten Verbindungspunkt über einen vierten Satz von Viertelwellenlängen-Übertragungsleitungen.

12. Das Verfahren nach Anspruch 11, wobei der besagte zweite Verbindungspunkt an eine Antenne gekoppelt ist.

13. Das Verfahren nach Anspruch 10 oder 11, wobei die besagten Schmalbandanpassungsstufen frequenzselektive Filter sind; wobei jeder Filter ein Sperrband, ein Durchlassband rund um eine Trägerfrequenz, einen Eingangsport, und einen Ausgangsport aufweist, wobei jeder Filter für eine maximale Reflexion an dem besagten Ausgangsport in den besagten Sperrbändern vorgesehen ist; wobei jede Schmalbandanpassungsstufe für ein verschiedenes Frequenzband vorgesehen ist.

14. Mobiles Mehrbandkommunikationssystem, welches eine Breitbandanpassung von Leistungsverstärkern anwendet, wobei das mobile Kommunikationssystem für die Durchführung gemäß einem beliebigen der vorstehenden Ansprüche 10 bis 13 betreibbar ist.

15. Computerprogramm-Produkt, welches auf einem Speichermedium gespeichert ist, umfassend ausführbare Programmmittel, um zu bewirken, dass ein Netzelement ein Verfahren nach einem beliebigen der vorstehenden Ansprüche 10 bis 13 ausführt, wenn das Programm auf dem Netzelement läuft.

## Revendications

1. Élément de réseau (200) pour l'adaptation à large bande d'un système de communication mobile multibande comprenant :
- un amplificateur de puissance (201) muni d'un premier port d'entrée (202) et d'un premier port de sortie (203) ;
- un premier ensemble d'étages d'adaptation à bande étroite (204), chaque étage d'adaptation à bande étroite dudit premier ensemble comprenant un deuxième port d'entrée (205) et un deuxième port de sortie (206) ;
- un premier ensemble de lignes de transmission en quart d'onde (207) qui relient lesdits deuxièmes ports de sortie (206) de chaque étage d'adaptation à bande étroite dudit premier ensemble (204) audit premier port d'entrée (202) dudit amplificateur de puissance (201) ;
- un deuxième ensemble d'étages d'adaptation à bande étroite (208) comprenant chacun un troisième port d'entrée (209) et un troisième port de sortie (210);
- un deuxième ensemble de lignes de transmission en quart d'onde (211) qui relient ledit troisième port d'entrée (209) de chaque étage d'adaptation à bande étroite dudit deuxième ensemble (208) audit premier port de sortie (203) dudit amplificateur de puissance (201).

2. Élément de réseau selon la revendication 1, dans lequel ledit premier et ledit deuxième ensembles d'étages d'adaptation à bande étroite (204, 208) sont des filtres à sélection de fréquence ; dans lequel chaque filtre possède une bande de coupure, une bande passante autour d'une fréquence porteuse ; dans lequel chaque filtre est conçu pour une réflexion maximale au niveau desdits ports de sortie dans lesdites bandes de coupure ; dans lequel chaque étage d'adaptation à bande étroite est conçu pour une bande de fréquences différente.

3. Élément de réseau selon la revendication 1 ou 2, dans lequel ledit premier (207) et ledit deuxième ensembles de lignes de transmission en quart d'onde (211) transforment une liaison en court-circuit en une liaison en circuit ouvert, dans lequel lesdits étages d'adaptation à bande étroite (204, 208) représentent un court-circuit au niveau desdits deuxièmes et troisièmes ports d'entrée et de sortie dans ladite bande de coupure.

4. Élément de réseau selon la revendication 1, dans lequel ledit premier ensemble d'étages d'adaptation à bande étroite transforme les impédances d'une première impédance au niveau desdits deuxièmes ports d'entrée en un ensemble de deuxièmes impédances au niveau desdits deuxièmes ports de sortie ; dans lequel ledit deuxième ensemble d'étages d'adaptation à bande étroite transforme l'impédance d'une troisième impédance au niveau dudit troisième port d'entrée en une quatrième impédance au niveau dudit troisième port de sortie.

5. Élément de réseau selon la revendication 1, dans lequel lesdits étages d'adaptation à bande étroite maximisent la transmission de puissance desdits ports d'entrée vers lesdits ports de sortie desdits premiers et deuxièmes ensembles.

6. Élément de réseau selon la revendication 1, dans lequel un troisième ensemble de lignes de transmission en quart d'onde (212) relie un premier point de connexion (213) auxdites deuxièmes entrées (205) dudit premier ensemble d'étages d'adaptation à bande étroite (204).

7. Élément de réseau selon la revendication 1, dans lequel un quatrième ensemble de lignes de transmission en quart d'onde (214) relie lesdits troisièmes ports de sortie (210) dudit deuxième ensemble d'étages d'adaptation à bande étroite (208) à un deuxième point de connexion (215).

8. Élément de réseau selon la revendication 7, dans lequel ledit deuxième point de connexion (215) est connecté à une antenne.

9. Élément de réseau selon l'une quelconque des revendications précédentes, dans lequel ledit premier (204) et ledit deuxième ensembles d'étages d'adaptation à bande étroite (208) sont adaptés pour ne pas produire de réflexion dans ladite bande passante au niveau desdits ports de sortie, dans lequel lesdits ports de sortie desdits filtres sont conçus comme des connexions en court-circuit dans lesdites bandes de coupure, dans lequel lesdites lignes de transmission en quart d'onde sont adaptées pour transformer ladite connexion en court-circuit en une connexion en circuit ouvert au niveau dudit premier et dudit deuxième points de connexion.

10. Procédé (500) d'adaptation à large bande sur des amplificateurs de puissance dans un élément de réseau d'un système de communication mobile multibande, le procédé comprenant:
- Émission (501) d'un signal de fréquence multibande d'un premier point de connexion vers les premiers ports d'entrée d'un premier ensemble d'étages d'adaptation à bande étroite par le biais d'un premier ensemble de lignes de transmission en quart d'onde ;
- Transformation (502) des impédances dans les multiples bandes de fréquences par ledit premier ensemble d'étages d'adaptation à bande étroite d'une première impédance au niveau desdits premiers ports d'entrée en un ensemble de deuxièmes impédances au niveau des premiers ports de sortie dudit premier ensemble d'étages d'adaptation à bande étroite ;
- Transmission (503) dudit signal multibande desdits ports de sortie dudit premier ensemble d'étages d'adaptation à bande étroite vers un deuxième port d'entrée d'un amplificateur de puissance par le biais d'un deuxième ensemble de lignes de transmission en quart d'onde ;
- Amplification (504) de la puissance dudit signal de fréquence multibande avec ledit amplificateur de puissance ;
- Transmission (505) dudit signal multibande d'un deuxième port de sortie dudit amplificateur de puissance vers les troisièmes ports de sortie d'un deuxième ensemble d'étages d'adaptation à bande étroite par le biais d'un troisième ensemble de lignes de transmission en quart d'onde.

11. Procédé selon la revendication 10 comprenant en outre :
- Transformation desdites impédances dans les multiples bandes de fréquences par ledit deuxième ensemble d'étages d'adaptation à bande étroite d'un troisième ensemble d'impédances au niveau desdits troisièmes ports d'entrée en une quatrième impédance au niveau des troisièmes ports de sortie dudit deuxième ensemble d'étages d'adaptation à bande étroite ;
- Transmission dudit signal multibande desdits troisièmes ports de sortie dudit deuxième ensemble d'étages d'adaptation à bande étroite vers un deuxième point de connexion par le biais d'un quatrième ensemble de lignes de transmission en quart d'onde.

12. Procédé selon la revendication 11, dans lequel ledit deuxième point de connexion est connecté à une antenne.

13. Procédé selon la revendication 10 ou 11, dans lequel lesdits étages d'adaptation à bande étroite sont des filtres à sélection de fréquence ; dans lequel chaque filtre possède une bande de coupure, une bande passante autour d'une fréquence porteuse, un port d'entrée, un port de sortie ; dans lequel chaque filtre est conçu pour une réflexion maximale au niveau dudit port de sortie dans lesdites bandes de coupure ; dans lequel chaque étage d'adaptation à bande étroite est conçu pour une bande de fréquences différente.

14. Système de communication mobile multibande appliquant l'adaptation à bande étroite des amplificateurs de puissance, le système de communication mobile pouvant être utilisé pour fonctionner conformément à l'une quelconque des revendications précédentes 10 à 13.

15. Produit de programme informatique stocké sur un support de stockage, comprenant des moyens de programme exécutables pour amener un élément de réseau à exécuter un procédé selon l'une quelconque des revendications précédentes 10 à 13 lorsque le programme est exécuté sur l'élément de réseau.
